(19)

Europäisches
Patentamt

European
Patent Office

Office européen
des brevets

(11)  EP 2 717 467 A1

(12)  EUROPEAN PATENT APPLICATION

(43) Date of publication:
09.04.2014  Bulletin 2014/15

(51) Int Cl.:
*H03F 3/217* (2006.01)          *H03K 17/16* (2006.01)
*H03K 5/01* (2006.01)           *H03K 19/003* (2006.01)

(21) Application number: 12275190.2

(22) Date of filing: 30.11.2012

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority:  08.10.2012  KR 20120111373

(71) Applicant: **Samsung Electro-Mechanics Co., Ltd
Suwon, Gyunggi-Do (KR)**

(72) Inventors:
• **Kim,, Myeung Su
Gyunggi-do (KR)**
• **Cho,, Koon Shik
Gyunggi-do (KR)**
• **Lim,, Joon Hyung
Gyunggi-do (KR)**

(74) Representative: **Potter Clarkson LLP
The Belgrave Centre
Talbot Street
Nottingham, NG1 5GG (GB)**

(54)    **Driver amplifier circuit and power amplifier including the same**

(57)    There are provided a driver amplifier circuit and a power amplifier including the same. The driver amplifier circuit includes a filtering unit that shapes an input waveform to have a curved form by using a plurality of invertors connected in parallel, a delay unit that applies different delays to a plurality of respective output waveforms output from the plurality of invertors, and an output unit that overlaps and outputs the plurality of output waveforms to which the different delays are applied by the delay unit, wherein the filtering unit eliminates a harmonic component by using a voltage drop due to internal resistance of the inverter.

FIG. 3

## Description

### CROSS-REFERENCE TO RELATED APPLICATIONS

This application claims the priority of Korean Patent Application No. 10-2012-0111373 filed on October 8, 2012, in the Korean Intellectual Property Office, the disclosure of which is incorporated herein by reference.

### BACKGROUND OF THE INVENTION

### Field of the Invention

The present invention relates to a driver amplifier circuit that may remove a harmonic component using internal resistance of an inverter element, and a power amplifier including the same.

### Description of the Related Art

According to the trend for the miniaturization of electronic devices, a System On Chip (SOC) is used in a variety of electronic devices. In particular, in portable electronic devices, requirements for low SOC power consumption have increased.

Accordingly, in regard to an SOC, an area thereof, as well as efficiency of power consumption, have emerged as important issues.

In electronic devices, power consumption mainly occurs in analog blocks, and in particular, a power amplifier may be of great importance in the power consumption of analog blocks. A power amplifier used for a low power SOC has low output characteristics in comparison with a general power amplifier. Therefore, in light of this, a voltage gain of a driver is generally designed to be high.

In recent years, in order to generate a rail-to-rail signal in the driver, an inverter has widely been used. There may be little static power consumption in a structure of the inverter, and therefore, the structure of the inverter has characteristics suitable for a low power structure.

However, when configuring the driver using the structure of the inverter, there is a problem in that an output signal may have the characteristics of a square wave, and a large number of harmonic signals may be included in the square wave.

Accordingly, in order to eliminate the harmonic signals, a separate additional filter may be used, or an inductor may be additionally applied to a load of an output terminal. However, in this case, there is a limitation in that a size of the circuit is increased.

The following related art documents relate to such existing technology, and still have a limitation in that a separate additional filter or a separate inductor is used so as to eliminate the harmonic signals.

[Related Art Document]

Korean Patent No. KR 10-1101515

Korean Patent No. KR 10-0861797

### SUMMARY OF THE INVENTION

An aspect of the present invention provides a driver amplifer circuit capable of having a simplified structure through eliminating a harmonic component using internal resistance of an inverter element, and a power amplifier including the same.

According to an aspect of the present invention, there is provided a driver amplifier circuit including: a filtering unit that shapes an input waveform to have a curved form by using a plurality of invertors connected in parallel; a delay unit that applies different delays to a plurality of respective output waveforms output from the plurality of invertors; and an output unit that overlaps and outputs the plurality of output waveforms to which the different delays are applied by the delay unit, wherein the filtering unit eliminates a harmonic component by using a voltage drop due to internal resistance of the inverter.

The filtering unit may include an upper inverter connected with a power supply terminal, a lower inverter connected with a ground terminal, a first inverter connected in series with the power supply terminal and the upper inverter,

and a second inverter connected in series with the lower inverter and the ground terminal.

The first and second inverters may output a waveform curved due to the internal resistance occurring between a drain terminal and a source terminal.

The upper and lower inverters may include a complementary metal oxide semiconductor (CMOS) that forms a complementary coupling.

The upper inverter may receive the curved waveform output from the first inverter as a source voltage of a P-type channel metal oxide semiconductor (PMOS).

The lower inverter may receive the curved waveform output from the second inverter as a source voltage of an n-type channel metal oxide semiconductor (NMOS).

The delay unit may include an upper delay element that applies a first delay to the output waveform from the upper inverter and a lower delay element that applies a second delay to the output waveform from the lower inverter, and the upper and lower delay elements may have mutually different delay values.

The delay unit may include a plurality of inverters connected in series.

The output unit may be an inverter that does not operate complementarily.

According to another aspect of the present invention, there is provided a power amplifier including a driver amplifier circuit, wherein the driver amplifier circuit includes: a filtering unit that shapes an input waveform to have a curved form by using a plurality of invertors connected in parallel; a delay unit that applies different delays to a plurality of respective output waveforms output from the plurality of invertors; and an output unit that overlaps and outputs the plurality of output waveforms to which the different delays are applied by the delay unit, the filtering unit eliminating a harmonic component by using a voltage drop due to internal resistance of the inverter.

The filtering unit may include an upper inverter connected with a power supply terminal, a lower inverter connected with a ground terminal, a first inverter connected in series with the power supply terminal and the upper inverter, and a second inverter connected in series with the lower inverter and the ground terminal.

The first and second inverters may output a waveform curved due to the internal resistance occurring between a drain terminal and a source terminal.

The upper inverter may include a CMOS that forms a complementary coupling.

The upper inverter may receive the curved waveform output from the first inverter as a source voltage of a PMOS, and the lower inverter may receive the curved waveform output from the second inverter as a source voltage of an NMOS.

The delay unit may include an upper delay element that applies a first delay to the output waveform from the upper inverter and a lower delay element that applies a second delay to the output waveform from the lower inverter, and the upper and lower delay elements may have mutually different delay values.

The delay unit may include a plurality of inverters connected in series.

The output unit may be an inverter that does not operate complementarily.

## BRIEF DESCRIPTION OF THE DRAWINGS

The above and other aspects, features and other advantages of the present invention will be more clearly understood from the following detailed description taken in conjunction with the accompanying drawings, in which:

FIG. 1 is a block diagram showing an example of a power amplifier;
FIGS. 2A and 2B are reference diagrams showing characteristics of a waveform of an inverter;
FIG. 3 is a circuit diagram showing an example of a driver amplifier circuit according to an embodiment of the present invention;
FIGS. 4 and 5 are reference diagrams showing characteristics of output waveforms of first and second inverter units of a driver amplifier circuit according to an embodiment of the present invention;
FIG. 6 is a reference diagram showing characteristics of a waveform of a driver amplifier circuit according to an embodiment of the present invention;
FIG. 7 is a reference diagram showing an output waveform of a driver amplifier circuit according to an embodiment of the present invention; and
FIG. 8 is a reference diagram illustrating characteristics of a waveform according to a delay of a driver amplifier circuit according to an embodiment of the present invention.

## DETAILED DESCRIPTION OF THE EMBODIMENTS

Hereinafter, embodiments of the present invention will be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art.

In the drawings, the shapes and dimensions of elements may be exaggerated for clarity, and the same reference numerals will be used throughout to designate the same or like elements.

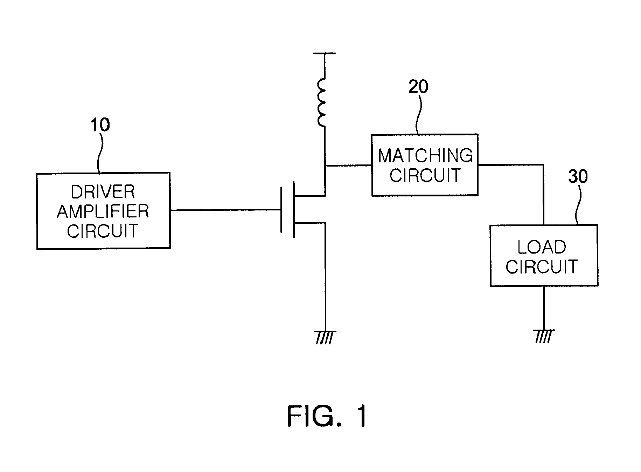

FIG. 1 is a block diagram showing an example of a power amplifier.

Referring to FIG. 1, the power amplifier may include a driver amplifier circuit 10, a matching circuit 20, and a load circuit 30.

According to the embodiment of the present invention, a driver amplifier circuit 10 including an inverter may be provided. Particularly, in the embodiment of the present invention, a harmonic component may be eliminated using a voltage drop due to internal resistance of the inverter.

Therefore, the present invention does not have a particular limitation to other configurations of the power amplifier except for the driver amplifier circuit 10. Accordingly, particular descriptions of other constituent components will be omitted. In addition, even in an embodiment of the power amplifier configured differently from that in FIG. 1, the power amplifier may be applied to the present invention as long as the power amplifier includes the driver amplifier circuit 10 which will be described below.

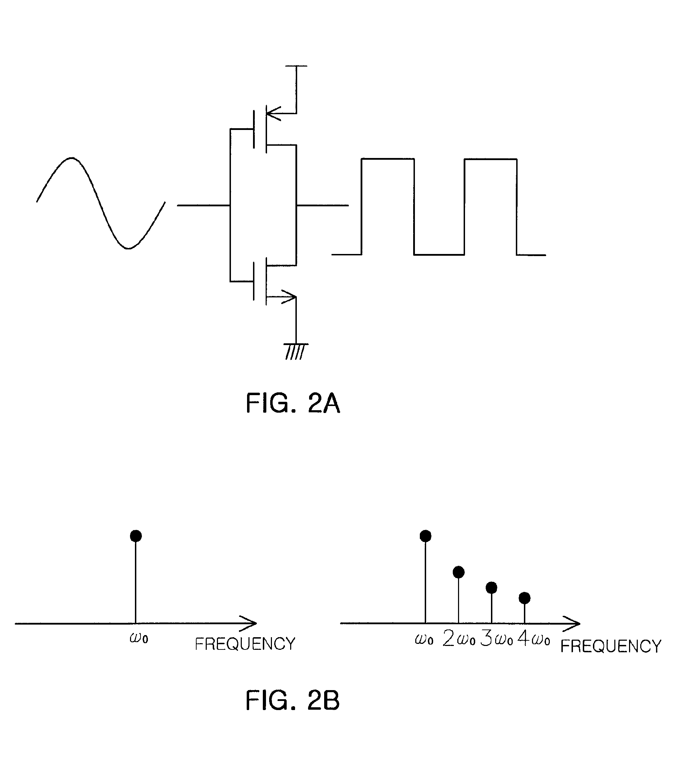

FIGS. 2A and 2B are reference diagrams showing characteristics of a waveform of an inverter.

As shown in FIG. 2A, in a complementary inverter structure (for example, metal oxide semiconductor (MOS)), it can be seen that an output signal corresponding to a square wave is output even in a case in which an input signal corresponding to a sine wave is input.

FIG. 2B is a graph showing harmonic components of the input and output signals, and as shown in FIG. 2B, it can be seen that the harmonic components are added to the output signal of the inverter to thereby be output as a square wave.

In the related art, in order to eliminate the harmonic components of the output signal, a separate additional filter is provided.

On the other hand, according to an embodiment of the present invention, an additional inverter element may be included therein, and a driver amplifier circuit that eliminates harmonic components by using internal resistance of the additional inverter element may be provided.

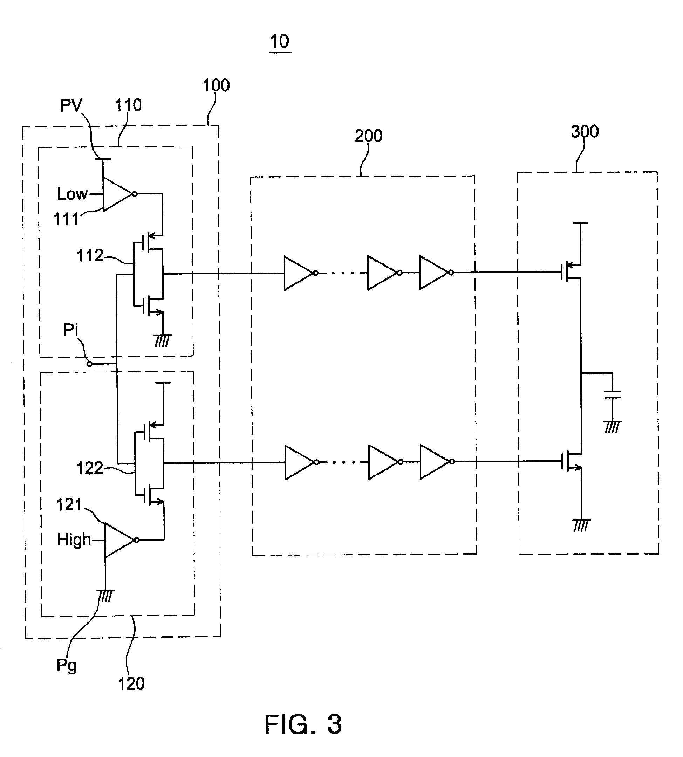

Hereinafter, the driver amplifier circuit 10 according to an embodiment of the present invention will be described with reference to FIGS. 3 to 8.

FIG. 3 is a configuration diagram showing an example of a driver amplifier circuit according to an embodiment of the present invention.

Referring to FIG. 3, the driver amplifier circuit 10 according to an embodiment of the present invention may include a filtering unit 100, a delay unit 200, and an output unit 300.

The filtering unit 100 may shape and output an input waveform. As shown in Fig. 3, the filtering unit 100 may shape the input waveform to have a curved form by using a plurality of inverters connected in parallel. Hereinafter, an example in which the filtering unit 100 includes an upper inverter 112 and a lower inverter 122 which are respectively connected to an upper portion of the filtering unit 100 and a lower portion thereof will be described, but this is only for the convenience of description, and the present invention is not necessarily limited thereto. That is, according to an embodiment of the present invention, a case in which at least three inverters connected in parallel are used may be applied.

The filtering unit 100 may include the upper inverter 112 connected with a power supply terminal (Pv), and the lower inverter 122 connected with a ground terminal (Pg). In an embodiment, the upper inverter 112 and the lower inverter 122 may be implemented as a complementary metal oxide semiconductor (CMOS) that forms a complementary coupling.

The filtering unit 100 may further include a first inverter 111 and a second inverter 121. Here, the first inverter 111 may be connected in series with the upper inverter 112 and the power supply terminal (Pv), and the second inverter 121 may be connected in series with the lower inverter 122 and the ground terminal (Pg).

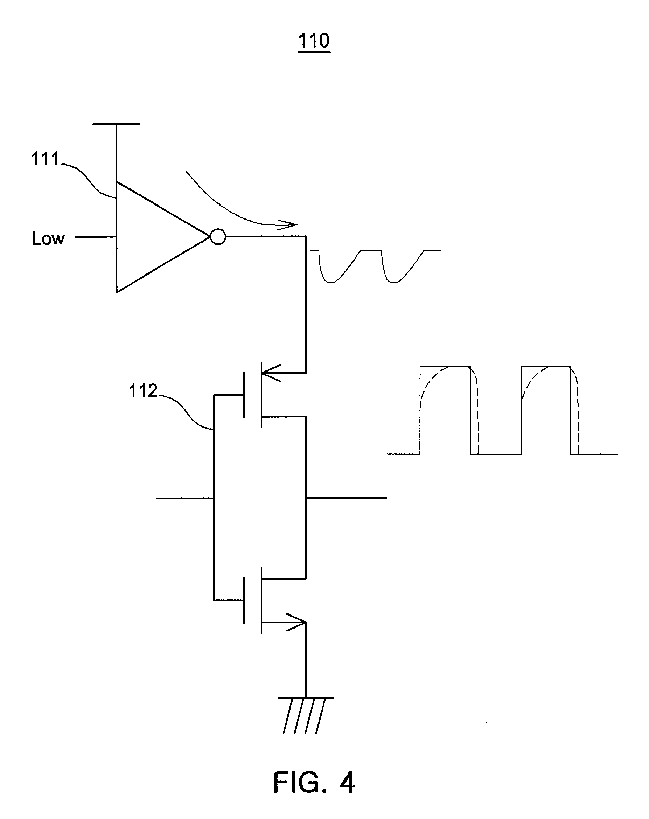

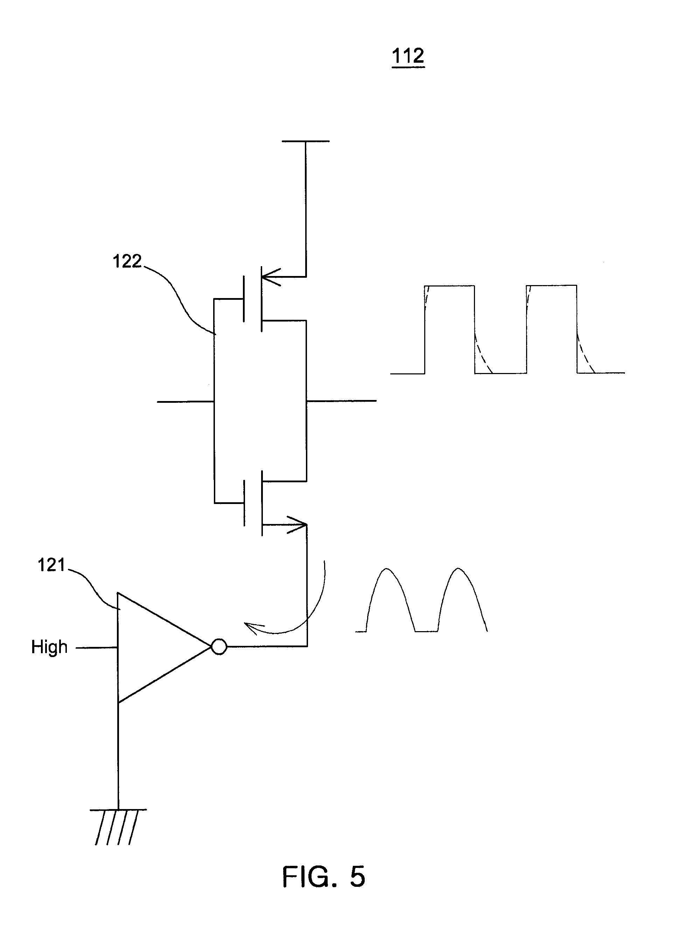

The filtering unit 100 may eliminate harmonic components using a voltage drop due to internal resistance of the first and second inverters 111 and 121. This will be described in more detail with reference to FIGS. 4 and 5.

The delay unit 200 may apply a delay to an output waveform of the filtering unit 100.

In an embodiment, when the filtering unit 100 includes a plurality of inverters connected in parallel, the delay unit 200 may apply different delays to outputs of the plurality of inverters connected in parallel.

In an example, the delay unit 200 may include an upper delay element connected in series with the upper inverter 112 and a lower delay element connected in series with the lower inverter 122. Here, the upper delay element may apply a first delay to an output waveform from the upper inverter 112, and the lower delay element may apply a second delay to an output waveform from the lower inverter 122. Here, the first and second delays may have different values.

The delay unit 200 may include a plurality of inverters connected in series.

In an example, the upper and lower delay elements may include different numbers of delays. That is, the number of delays of the upper delay element and the number of delays of the lower delay element may be different, and therefore the first delay value and the second delay value may be differently set.

The delay unit 200 may output waveforms to which the different first and second delays are applied, and the output unit 300 may overlap the waveforms to which the different first and second delays are applied, thereby effectively eliminating a harmonic wave.

The output unit 300 may overlap and output a plurality of output waveforms to which different delays are applied by the delay unit 200.

In an embodiment, the output unit 300 may include inverters which are not operated complementarily with each other.

FIGS. 4 and 5 are reference diagrams showing characteristics of waveforms of first and second inverter units of a driver amplifier circuit according to an embodiment of the present invention. Hereinafter, the feature in which harmonic components are eliminated using a voltage drop due to internal resistance of the first and second inverters 111 and 121 will be described in detail with reference to FIGS. 4 and 5.

FIG. 4 shows characteristics of output waveforms of the first inverter 111 and the upper inverter 112.

The first inverter 111 may be connected in series between the power supply terminal (Pv) and the upper inverter 112, and may output a predetermined square wave using the internal resistance.

When a low voltage is applied to the first inverter 111, the first inverter 111 may output a waveform curved by internal resistance (RDS) occurring between a drain terminal and a source terminal. That is, when the low voltage is applied to the first inverter 111, a P-type channel metal oxide semiconductor (PMOS) of the first inverter 111 may be turned ON, and therefore the curved waveform may be output by the influence of the internal resistance (channel resistance Rch) occurring between the drain terminal and the source terminal.

The upper inverter 112 may receive, as a source voltage of the PMOS, the curved waveform output from the first inverter 111. Accordingly, when a low voltage is applied to the upper inverter 112, the PMOS is turned ON, and therefore a current flows in the PMOS. A voltage drop in the internal resistance of the first inverter 111 is reflected in such a current, and therefore the upper inverter 112 may output a waveform in which a portion of a corner thereof is curved.

That is, according to the embodiment of the present invention, a separate inverter (first inverter) may be added to the power supply terminal (Pv), and a waveform having a curved portion at a corner thereof by using internal resistance (RDS) of the added inverter (first inverter) may be provided. Such internal resistance Rch may be represented by the following Equation 1.

[Equation 1]

$$R_{ch} = \frac{L}{\mu C_{ox} W (V_g - V_t - V_{ds}/2)}$$

Here, "$\mu$" denotes mobility, "Cox" denotes a gate oxide capacitance, "W" denotes a channel width, "Vg" denotes a gate voltage, "Vt" denotes a threshold voltage, "Vds" denotes a drain-source voltage, and "L" denotes a channel length.

FIG. 5 shows characteristics of output waveforms of the second inverter 121 and the lower inverter 122.

As shown in FIG. 5, the lower inverter 122 may receive the curved waveform output from the second inverter 121 as a source voltage of an NMOS to thereby output a curved waveform. Such an operational principle corresponds to that described in FIG. 4, and therefore the detailed description thereof will be omitted.

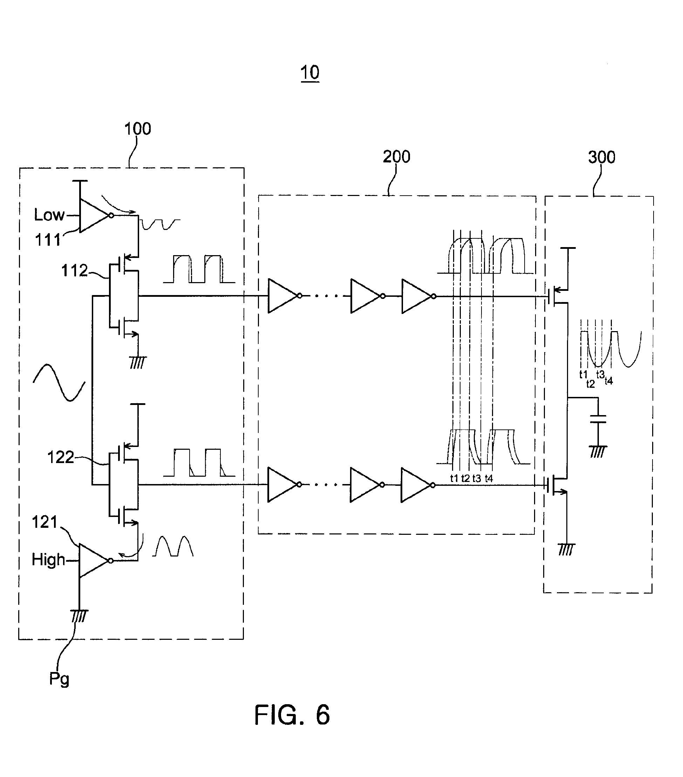

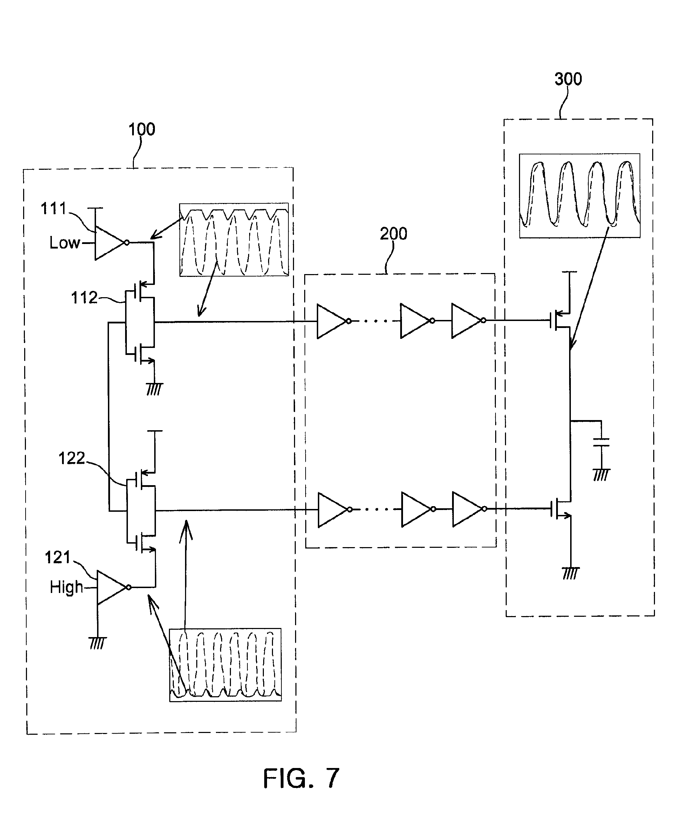

FIG. 6 is a reference diagram showing characteristics of a waveform of a driver amplifier circuit according to an embodiment of the present invention, and FIG. 7 is a reference diagram showing an output waveform of a driver amplifier circuit according to an embodiment of the present invention.

As shown in FIGS. 6 and 7, as an output of the upper inverter 112, a signal having a curved form, different from a square wave, may be obtained due to the influence of the first inverter 111, and therefore the output of the upper inverter 112 may be delayed.

As described above, different delays are applied to the outputs of the upper and lower inverters 112 and 122. That is, phases of the outputs of the upper and lower inverters 112 and 122 may be provided to be different, and may be penetrated respectively through the PMOS and NMOS of the output unit 300 to thereby be overlapped. Here, the inverters of the output unit 300 may not operate complementarily, but may operate in a plurality of sections (four sections in the shown example), and therefore the harmonic components may be eliminated to thereby output signals close to a sine wave.

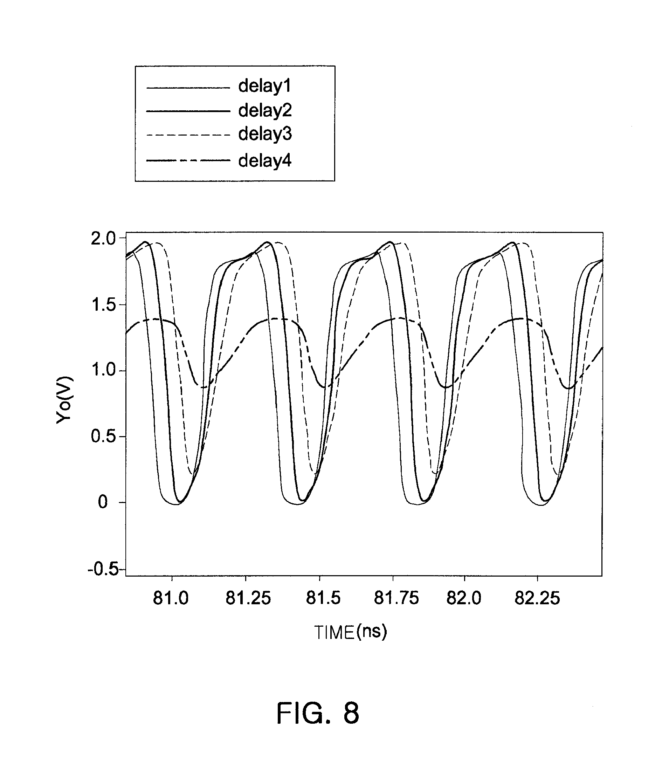

FIG. 8 is a reference diagram illustrating characteristics of a waveform based on a delay of a driver amplifier circuit according to an embodiment of the present invention. Here, an example in which a delay 1 is 1/8, a delay 2 is 1/4, a delay 3 is 3/8, and a delay 4 is 1/2 is shown.

As shown in FIG. 8, more improved performance is shown in the order of the delays 3, 1, 2 and 4.

As set forth above, according to embodiments of the present invention, harmonic components may be eliminated using the internal resistance of the inverter element, whereby the driver amplifier circuit may be simply configured without an additional filter or inductor.

While the present invention has been shown and described in connection with the embodiments, it will be apparent to those skilled in the art that modifications and variations can be made without departing from the spirit and scope of the invention as defined by the appended claims.

**Claims**

1.    A driver amplifier circuit comprising:

> a filtering unit shaping an input waveform to have a curved form by using a plurality of invertors connected in parallel;
> a delay unit applying different delays to a plurality of respective output waveforms output from the plurality of invertors; and
> an output unit overlapping and outputting the plurality of output waveforms to which the different delays are applied by the delay unit,
> the filtering unit eliminating a harmonic component by using a voltage drop due to internal resistance of the inverter.

2.    The driver amplifier circuit of claim 1, wherein the filtering unit includes:

> an upper inverter connected with a power supply terminal;
> a lower inverter connected with a ground terminal;
> a first inverter connected in series with the power supply terminal and the upper inverter; and
> a second inverter connected in series with the lower inverter and the ground terminal.

3.    The driver amplifier circuit of claim 2, wherein the first and second inverters output a waveform curved due to the internal resistance occurring between a drain terminal and a source terminal.

4.    The driver amplifier circuit of claim 3, wherein the upper and lower inverters include a complementary metal oxide semiconductor (CMOS) that forms a complementary coupling.

5.    The driver amplifier circuit of claim 4, wherein the upper inverter receives the curved waveform output from the first inverter as a source voltage of a P-type channel metal oxide semiconductor (PMOS).

6.    The driver amplifier circuit of claim 4, wherein the lower inverter receives the curved waveform output from the second inverter as a source voltage of a n-type channel metal oxide semiconductor (NMOS).

7.    The driver amplifier circuit of claim 2, wherein the delay unit includes:

> an upper delay element that applies a first delay to the output waveform from the upper inverter; and
> a lower delay element that applies a second delay to the output waveform from the lower inverter, and
> the upper and lower delay elements have mutually different delay values.

8.    The driver amplifier circuit of claim 1, wherein the delay unit includes a plurality of inverters connected in series.

9.    The driver amplifier circuit of claim 1, wherein the output unit is an inverter that does not operate complementarily.

10.   A power amplifier comprising a driver amplifier circuit,
the driver amplifier circuit including:

> a filtering unit shaping an input waveform to have a curved form by using a plurality of invertors connected in parallel;
> a delay unit applying different delays to a plurality of respective output waveforms output from the plurality of invertors; and

an output unit overlapping and outputting the plurality of output waveforms to which the different delays are applied by the delay unit,

the filtering unit eliminating a harmonic component by using a voltage drop due to internal resistance of the inverter.

11. The power amplifier of claim 10, wherein the filtering unit includes:

an upper inverter connected with a power supply terminal;

a lower inverter connected with a ground terminal;

a first inverter connected in series with the power supply terminal and the upper inverter; and

a second inverter connected in series with the lower inverter and the ground terminal.

12. The power amplifier of claim 11, wherein the first and second inverters output a waveform curved due to the internal resistance occurring between a drain terminal and a source terminal.

13. The power amplifier of claim 12, wherein the upper inverter includes a CMOS that forms a complementary coupling.

14. The power amplifier of claim 13, wherein the upper inverter receives the curved waveform output from the first inverter as a source voltage of a PMOS, and

the lower inverter receives the curved waveform output from the second inverter as a source voltage of an NMOS.

15. The power amplifier of claim 11, wherein the delay unit includes:

an upper delay element that applies a first delay to the output waveform from the upper inverter; and

a lower delay element that applies a second delay to the output waveform from the lower inverter, and

the upper and lower delay elements have mutually different delay values.

16. The power amplifier of claim 10, wherein the delay unit includes a plurality of inverters connected in series.

17. The power amplifier of claim 10, wherein the output unit is an inverter that does not operate complementarily.

FIG. 1

FIG. 2A

FIG. 2B

FIG. 3

110

111

Low

112

FIG. 4

_112_

**FIG. 5**

FIG. 6

FIG. 7

FIG. 8

Europäisches
Patentamt

European
Patent Office

Office européen
des brevets

**EUROPEAN SEARCH REPORT**

Application Number

EP 12 27 5190

**DOCUMENTS CONSIDERED TO BE RELEVANT**

| Category | Citation of document with indication, where appropriate, of relevant passages | Relevant to claim | CLASSIFICATION OF THE APPLICATION (IPC) |
|---|---|---|---|
| A | US 2001/026178 A1 (ITOH KUNIHIRO [JP] ET AL) 4 October 2001 (2001-10-04) * paragraph [0001] - paragraph [0008]; figures 1,6,7,10-14 * ----- | 1-17 | INV. H03F3/217 H03K17/16 H03K5/01 H03K19/003 |
| A | US 6 255 867 B1 (CHEN BAOHUA [US]) 3 July 2001 (2001-07-03) * abstract; figure 1 * ----- | 1,10 | |
| | | | TECHNICAL FIELDS SEARCHED (IPC) H03F H03K |

The present search report has been drawn up for all claims

| Place of search | Date of completion of the search | Examiner |
|---|---|---|
| The Hague | 24 October 2013 | Van den Doel, Jules |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 12 27 5190

This annex lists the patent family members relating to the patent documents cited in the above-mentioned European search report.
The members are as contained in the European Patent Office EDP file on
The European Patent Office is in no way liable for these particulars which are merely given for the purpose of information.

24-10-2013

| Patent document cited in search report | | Publication date | Patent family member(s) | | Publication date |
|---|---|---|---|---|---|
| US 2001026178 | A1 | 04-10-2001 | KR 20010094927 | A | 03-11-2001 |
| | | | TW 525345 | B | 21-03-2003 |
| | | | US 2001026178 | A1 | 04-10-2001 |
| | | | US 2005189964 | A1 | 01-09-2005 |
| US 6255867 | B1 | 03-07-2001 | NONE | | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020120111373
- KR 101101515
- KR 100861797